Europäisches Patentamt

European Patent Office

Office européen des brevets

(19)

(11) **EP 1 115 920 B1**

(12) **FASCICULE DE BREVET EUROPEEN**

(45) Date de publication et mention
de la délivrance du brevet:
**29.01.2003 Bulletin 2003/05**

(21) Numéro de dépôt: **99941731.4**

(22) Date de dépôt: **10.09.1999**

(51) Int Cl.[7]: **C30B 25/02**, C30B 29/08,
C30B 29/52

(86) Numéro de dépôt international:
**PCT/FR99/02154**

(87) Numéro de publication internationale:
**WO 00/015885 (23.03.2000 Gazette 2000/12)**

(54) **PROCEDE D'OBTENTION D'UNE COUCHE DE GERMANIUM MONOCRISTALLIN SUR UN SUBSTRAT DE SILICIUM MONOCRISTALLIN, ET PRODUITS OBTENUS**

**VERFAHREN ZUR HERSTELLUNG EINER EINKRISTALLINEN SCHICHT AUS GERMANIUM AUF EINEM EINKRISTALLINEN SILIZIUMSUBSTRAT UND DADURCH HERGESTELLTE PRODUKTE**

**METHOD FOR OBTAINING A MONOCRYSTALLINE GERMANIUM LAYER ON A MONOCRYSTALLINE SILICON SUBSTRATE, AND RESULTING PRODUCTS**

(84) Etats contractants désignés:
**BE DE GB IT NL**

(30) Priorité: **10.09.1998 FR 9811313**

(43) Date de publication de la demande:
**18.07.2001 Bulletin 2001/29**

(73) Titulaire: **FRANCE TELECOM**
**75015 Paris (FR)**

(72) Inventeurs:
• **HERNANDEZ, Caroline**
**F-38000 Grenoble (FR)**
• **CAMPIDELLI, Yves**
**F-38000 Grenoble (FR)**
• **BENSAHEL, Daniel**
**F-38000 Grenoble (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**EP-A- 0 518 800**      **EP-A- 0 524 114**

• **KOBAYASHI S ET AL: "Initial growth characteristics of germanium on silicon in LPCVD using germane gas" JOURNAL OF CRYSTAL GROWTH, vol. 174, no. 1-4, 1 avril 1997 (1997-04-01), page 686-690 XP004083870**
• **JUNG K H ET AL: "GROWTH OF GEXSI1-X LAYERS BY RAPID THERMAL PROCESSING CHEMICAL VAPOR DEPOSITION" EXTENDED ABSTRACTS, vol. 89/1, no. 22, 1989, page 216/217 XP000133701**
• **KAMINS T I ET AL: "KINETICS OF SILICON-GERMANIUM DEPOSITION BY ATMOSPHERIC-PRESSURE CHEMICAL VAPOR DEPOSITION" APPLIED PHYSICS LETTERS, vol. 59, no. 2, 8 juillet 1991 (1991-07-08), pages 178-180, XP000230517**
• **FITZGERALD E A ET AL: "Line, point and surface defect morphology of graded, relaxed GeSi alloys on Si substrates" THIN SOLID FILMS, vol. 294, no. 1-2, 15 février 1997 (1997-02-15), page 3-10 XP004073025 cité dans la demande**

**Description**

La présente invention concerne de manière générale un procédé d'obtention d'une couche de germanium monocristallin sur un substrat de silicium monocristallin.

Le silicium (Si) est le composé de base de la micro-électronique. Il est disponible actuellement sur le marché en tranches de 200 mm de diamètre. Les limites en termes de performance des circuits intégrés sont donc en définitive celles liées aux propriétés intrinsèques du silicium. Parmi ces propriétés, on peut citer la mobilité électronique.

Le germanium (Ge) qui fait partie de la colonne IV de la classification périodique des éléments est un semi-conducteur. Il serait potentiellement plus intéressant que Si car, (i) il possède une mobilité électronique plus élevée, (ii) il absorbe bien dans le domaine du rayonnement infrarouge, (iii) son paramètre de maille est plus grand que celui de Si, ce qui autorise les hétéro-épitaxies avec les matériaux semiconducteurs des colonnes III-V de la classification périodique.

Malheureusement, le germanium ne possède pas d'oxyde stable et on ne trouve pas sur le marché de plaquettes de germanium de grand diamètre ou alors à des prix prohibitifs.

On a déjà fait croître des alliages $Si_{1-x}Ge_x$ sur des substrats de Si monocristallin. Les alliages obtenus ne dépassent que rarement des taux de 50% en germanium dans l'alliage.

D'autre part, lorsque l'on fait croître des alliages SiGe sur du Si monocristallin, la croissance de l'alliage SiGe est au départ monocristalline. Plus l'épaisseur de la couche et sa teneur en germanium sont élevées, plus la couche devient "contrainte". Au-delà d'une certaine épaisseur, la "contrainte" devient trop forte et la couche se relaxe en émettant des dislocations. Ces dislocations ont un effet délétère sur les futurs circuits qui seront construits sur cette couche et la relaxation des couches fait perdre certains avantages de la structure de bandes contrainte (décalage des bandes de conduction et de valence suivant les états de contrainte : Si/SiGe ou SiGe/Si). A chaque composition et à chaque température d'élaboration correspond donc une couche contrainte d'épaisseur maximum.

Dans certaines applications, on a développé le concept de "substrats relaxés", c'est-à-dire que l'on fait croître des couches de $Si_{1-x}Ge_x$ sur du silicium en dépassant l'épaisseur critique pour une composition donnée mais en ajustant les paramètres de dépôt des couches pour que les dislocations émises ne se propagent pas verticalement mais se courbent pour se propager dans le plan de la couche pour ensuite s'évaporer sur les bords de la plaque. La croissance s'effectue donc à partir de couches de plus en plus enrichies en germanium, le gradient en germanium pouvant se faire par palier ou continûment.

Mais les dépôts obtenus par ce procédé de "substrats relaxés" possèdent, soit un taux d'enrichissement en germanium relativement faible (< 50%), soit présentent une densité de dislocations émergentes inacceptable pour des applications en micro-électronique.

Ainsi, l'article intitulé "Stepwise equilibrated graded $Ge_xSi_{1-x}$ buffer with very low threading dislocation density on Si (001), G. Kissinger, T. Morgenstern, G. Morgenstern et H. Richter, Appl. Phy. Lett. 66 (16), 17 Avril 1995", décrit un procédé dans lequel on dépose sur un substrat la séquence de couches suivantes :

$$250 \text{ nm } Ge_{0,05}Si_{0,95} + 100 \text{ nm } Ge_{0,1}Si_{0,9}$$

$$+ 100 \text{ nm } Ge_{0,15}Si_{0,85} + 150 \text{ nm } Ge_{0,2}Si_{0,8}.$$

Chaque couche est, après dépôt, soumise à un recuit in situ dans l'hydrogène à 1095 ou 1050°C. A titre de comparaison, des séquences semblables de couches ont été déposées, mais sans recuit.

Une couche de 300 nm de $Ge_xSi_{1-x}$ de même composition que la couche tampon supérieure est également déposée sur celle-ci.

Les échantillons qui n'ont pas été soumis aux recuits intermédiaires présentent une densité de dislocations émergentes de $10^6$ cm$^{-2}$, cependant que l'échantillon ayant subi les recuits présente une densité de dislocations émergentes de $10^3$ - $10^4$ cm$^{-2}$.

L'article intitulé "Line, point and surface defect morphology of graded, relaxed GeSi alloys on Si substrates", E.A. Fitzgerald, S.B. Samavedam,Thin Solid Films, 294, 1997, 3-10, décrit la fabrication de substrats relaxés comportant jusqu'à 100% de germanium. Mais le procédé employé est long (de l'ordre de plus de 4 heures par plaque) et par conséquent inattractif du point de vue industriel. D'autre part, ce procédé n'est pas réversible, c'est-à-dire qu'il ne permet pas de réaliser des dépôts de silicium pur sur un substrat de germanium.

En outre, lors de la fabrication de tels substrats relaxés, on observe une rugosité de surface qui augmente suivant les conditions dépôt et qui peut avoir des effets négatifs car cumulatifs, c'est-à-dire qu'un début de rugosité ne fait que s'amplifier au cours du dépôt.

On a également proposé un procédé de dépôt permettant de former sur un substrat de silicium des couches de $Si_{1-x}Ge_x$ (x variant de 0 à 1), pouvant aller jusqu'à une couche de Ge pur et présentant une faible densité de dislocations émergentes.

La caractéristique essentielle de ce procédé consiste, lors du dépôt chimique en phase vapeur, à modifier en permanence le flux de gaz actifs ($SiH_4$ et $GeH_4$, par exemple) en même temps que l'on fait varier la température de dépôt. Àinsi, on rejette et évacue rapidement les dislocations émises pour relaxer au fur et à mesure la couche en croissance. On peut ainsi obtenir ses substrats relaxés allant d'une concentration en Ge égale à zéro (substrat Si) à une concentration en Ge de 100% avec un dépôt de 4 à 5 µm alors que les techniques antérieures exigent des couches intermédiaires de plus de 10 µm (typiquement autour de 25 µm).

Ce dernier procédé a donc pour avantages une épaisseur plus faible de couche intermédiaire pour obtenir une couche superficielle de substrat relaxé, une densité de défauts (dislocations émergentes) faible de $10^5$ défauts/$cm^2$ environ (comparés à $10^6$ pour les procédés antérieurs).

Toutefois, ce dernier procédé exige toujours le dépôt d'une couche intermédiaire présentant un gradient de concentration en Ge, ce qui nécessite des épaisseurs de dépôt de l'ordre de 4 à 5 µm.

D'autre part, cette technique nécessite également de longs temps de dépôt, de plus d'une heure par plaque traitée dans certains cas, ce qui diminue le débit de plaques à l'heure et accroît le coût de fabrication des plaques.

La présente invention a donc pour objet un nouveau procédé de dépôt d'une couche de germanium pur monocristallin sur un substrat de silicium monocristallin, qui ne nécessite pas le dépôt d'une couche intermédiaire à gradient de concentration.

La présente invention a encore pour objet un tel procédé de dépôt fournissant de faibles densités de dislocations émergentes résiduelles, inférieures à $10^3$ défauts/$cm^2$ en surface.

La présente invention a aussi pour objet un tel procédé, permettant l'obtention d'une couche dans un temps très court et de faible épaisseur (10 minutes environ pour une couche de Ge pur de 1µm).

Selon un premier mode de réalisation de l'invention, le procédé de formation sur un substrat de silicium monocristallin d'une couche de germanium pur monocristallin comprend :

(a) la stabilisation en température du substrat de silicium monocristallin à une première température stabilisée prédéterminée ($T_1$) de 400°C à 500°C, de préférence de 430°C à 460°C;

(b) le dépôt chimique en phase vapeur (CVD) de germanium à ladite première température prédéterminée ($T_1$) jusqu'à obtention d'une couche de base de germanium sur le substrat d'une épaisseur prédéterminée inférieure à une épaisseur finale voulue;

(c) l'accroissement de la température de dépôt chimique en phase vapeur du germanium depuis la première température prédéterminée ($T_1$) jusqu'à une seconde température prédéterminée ($T_2$) allant de 750°C à 850°C, de préférence de 800 à 850°C; et

(d) la poursuite du dépôt chimique en phase vapeur du germanium à ladite seconde température prédéterminée ($T_2$) jusqu'à obtention de l'épaisseur finale voulue pour la couche de germanium monocristallin.

Selon un deuxième mode de réalisation de l'invention, le procédé de formation sur un substrat de silicium monocristallin d'une couche de germanium pur monocristallin comprend après l'étape (c) et avant l'étape (d) :

- ($c_1$) une étape dans laquelle on arrête le dépôt CVD de germanium et on abaisse la température depuis la seconde température prédéterminée ($T_2$) jusqu'à une troisième température prédéterminée ($T_3$) de 500 à 600°C, de préférence de 540 à 560°C;

- ($c_2$) une étape de dépôt chimique en phase vapeur à la troisième température prédéterminée ($T_3$) d'un alliage $Si_{1-x}Ge_x$ où $x \geq 0{,}9$, jusqu'à obtention d'une couche intermédiaire d'alliage $Si_{1-x}Ge_x$ ayant une épaisseur prédéterminée;

- ($c_3$) une étape de transition dans laquelle, à la troisième température prédéterminée ($T_3$), on passe du dépôt chimique en phase vapeur de l'alliage $Si_{1-x}Ge_x$ à un dépôt chimique en phase vapeur de Ge pur;

- ($c_4$) une étape dans laquelle on poursuit le dépôt CVD de germanium à ladite troisième température prédéterminée ($T_3$) de manière à obtenir un empilement de couches comprenant la couche de base de germanium, une couche intermédiaire d'alliage $Si_{1-x}Ge_x$ et une couche supérieure de germanium, l'épaisseur de l'empilement étant inférieure à l'épaisseur finale voulue; et

- ($c_5$) une étape dans laquelle on accroît la température du dépôt chimique en phase vapeur du germanium depuis la troisième température prédéterminée ($T_3$) jusqu'à une quatrième température prédéterminée ($T_4$) de 750 à 850°C, de préférence 800 à 850°C;

l'étape (d) s'effectuant à cette quatrième température prédéterminée ($T_4$), identique ou différente de la deuxième température prédéterminée ($T_2$), mais de préférence identique.

Pour les dépôts chimiques en phase vapeur de germanium pur, on peut utiliser tous gaz précurseurs du germanium tel que $GeH_4$. Comme cela est bien connu, le gaz précurseur de germanium est dilué avec un gaz porteur tel que l'hydrogène. Les facteurs de dilution peuvent varier de 10 à 1000. De préférence, le rapport en volume $GeH_4/H_2$ est de 10%.

Les dépôts de germanium s'effectuent de préférence à la pression atmosphérique, car lorsque la pression totale est inférieure à 500 hPa, les dépôts deviennent très vite rugueux et la densité de dislocations émergentes augmente.

L'étape de stabilisation de la température du substrat de silicium (a) s'effectue en l'absence de tout gaz réactif, mais en présence du gaz porteur, généralement $H_2$.

Dans toutes les étapes de dépôt chimique en phase vapeur, on utilise de préférence comme gaz porteur $H_2$ avec un débit de 20 l/minute, environ (purifié ou non).

Dans les étapes de dépôt de germanium pur, le gaz précurseur est de préférence $GeH_4$ et le flux est généralement compris entre 30 et 400 $cm^3$/minute dans les conditions standard, la valeur optimale étant de 300 $cm^3$/minute (il s'agit bien évidemment de valeurs de flux nominal de $GeH_4$ dilué à 10% en volume dans $H_2$).

Les durées des étapes de dépôt CVD de germanium sont bien évidemment déterminées en fonction de l'épaisseur voulue pour la couche de germanium finale.

Ainsi, dans le premier mode de réalisation de l'invention, avec les conditions préférentielles ci-dessus, une durée de 10 minutes de l'étape (b), de 60 secondes de l'étape (c) et de 120 secondes de l'étape (d), on obtient une couche finale de germanium pur monocristallin de 1 µm environ présentant une densité de dislocations émergentes extrêmement faible, pouvant être inférieure à 10 défauts/$cm^2$.

Dans le cas du second mode de réalisation de l'invention, toutes les étapes s'effectuent également en présence d'un gaz porteur, de préférence l'hydrogène et également de préférence à la pression atmosphérique.

L'étape d'abaissement de la température ($c_1$) s'effectue en l'absence de gaz précurseurs réactifs, mais en présence de gaz porteur, par exemple de l'hydrogène.

Les dépôts CVD de germanium, mis à part les températures de dépôt, s'effectuent dans les mêmes conditions que précédemment.

Le dépôt CVD de la couche d'alliage $Si_{1-x}Ge_x$ s'effectue en utilisant un mélange de gaz précurseurs de germanium et de silicium dans les proportions voulues pour obtenir un dépôt d'alliage $Si_{1-x}Ge_x$ comportant au moins 90 atomes % de germanium. Le gaz précurseur de germanium recommandé est $GeH_4$. Les gaz précurseurs du silicium recommandés sont $SiH_4$, $Si_2H_6$, $SiH_2Cl_2$, $SiHCl_3$, $SiCl_4$ et $Si(CH_3)_4$, $SiH_4$ étant préféré.

La couche intermédiaire d'alliage SiGe aura généralement une épaisseur comprise entre 5 et 10 nm, de préférence de l'ordre de 10 nm, et bien évidemment les conditions de dépôt CVD de cette couche seront choisies pour satisfaire les exigences d'épaisseur et de teneur en germanium de la couche. En particulier, si la teneur en germanium de cette couche intermédiaire d'alliage SiGe est inférieure à 90 atomes %, la densité de dislocations émergentes augmente.

Le procédé selon l'invention peut comporter, préalablement à l'étape (a) de stabilisation de la température du substrat, une étape d'imprégnation de la surface du substrat par dépôt CVD en phase vapeur d'une couche de silicium à une température de 500 à 600°C, de préférence de 550°C. Cette étape de dépôt CVD s'effectue également de préférence à la pression atmosphérique. Le gaz précurseur préféré est $SiH_4$ et comme cela est bien connu, le dépôt s'effectue en présence d'un gaz porteur, de préférence l'hydrogène.

L'épaisseur de la couche de silicium d'imprégnation est en général de 1 à 5 nm, de préférence de l'ordre de 3 nm.

Bien que cela ne soit pas très bien compris, la présence d'une telle couche d'imprégnation réduit la densité de dislocations émergentes dans le produit final.

De préférence encore, on soumet la surface du substrat à une étape de préparation préalablement à la mise en oeuvre du procédé selon l'invention.

Cette étape de préparation peut être classiquement une étape de nettoyage de la surface, par exemple tout procédé en phase liquide ou gazeuse qui nettoie la surface de silicium des résidus métalliques et organiques, comme les solutions classiques SC1 ($NH_4OH + H_2O_2$) et $SC_2$ ($HCl + H_2O_2$) ou encore $H_2SO_4 + H_2O_2$. Dans tous les cas, le nettoyage s'achève par une phase de traitement par une solution aqueuse diluée de HF suivie d'un rinçage à l'eau.

Les produits obtenus par le procédé selon l'invention présentent en général une densité de dislocations émergentes $\leq 10^3$/$cm^2$ et pouvant même être inférieure à 10 défauts/$cm^2$.

Bien que le procédé décrit ci-dessus limite l'apparition d'une rugosité de surface, il est encore souhaitable de réduire la rugosité de surface du dépôt de germanium.

Pour supprimer la rugosité, on peut utiliser dans la présente invention tout type de polissage mécano-chimique classiquement utilisé dans la technologie du silicium.

Le principe du polissage mécano-chimique est connu et classique et consiste à frotter la plaque à polir sur un tissu imbibé d'abrasif, en appliquant une pression et un déplacement sur cette plaque par rapport au tissu. Les effets mécaniques et chimiques conjugués provoquent le retrait de molécules du matériau poli préférentiellement sur les zones en relief et induisent l'aplanissement du matériau à polir.

Le contrôle du polissage se fait, soit in-situ par contrôle de données du polissage comme le courant des moteurs, soit ex-situ de façon qualitative par observation optique ou microscopique, et/ou de façon quantitative par technique de microscopie à force atomique [mesure de la rugosité moyenne (rms) ou sommet/vallée].

Après polissage, il peut subsister des résidus mécaniques (incrustés) sur la surface qui seront enlevés par un brossage mécanique et rinçage.

Après ce nettoyage, le polissage peut laisser une zone perturbée en surface et un traitement de régénération de la surface peut être nécessaire. Ce traitement qui sera de type gravure devra néanmoins être effectué sans faire disparaître toute la couche active. Plusieurs voies sont possibles.

On peut, soit (i) graver par voie sèche ou humide la couche, soit (ii) oxyder la surface puis dissoudre l'oxyde. Ces deux moyens utiliseront la sensibilité extrême du Ge à l'oxygène (gazeux ou ozone ou ozone dissout dans l'eau, ou plasma ...), les oxydes de Ge étant volatils ou instables.

On peut, après ces traitements, reprendre une épitaxie sur la surface, en particulier selon le procédé de l'invention décrit ci-dessus. Dans ce cas préféré, on obtient immédiatement l'état de la surface voulu (comptage de défauts) et donc une couche "garantie" dont on peut ajuster l'épaisseur en fonction de l'application envisagée. De plus, on obtient un piégeage des impuretés par le réseau de dislocations sous-jacent.

Les procédés qui viennent d'être décrits permettent donc d'obtenir des couches de germanium de structure monocristalline directement déposées sur du silicium qui sont de très bonne qualité, et qui permettent une reprise de dépôt par hétéroépitaxies d'éléments des groupes III à V de la classification périodique et de composés de ceux-ci (hétéroépitaxie III-V) tel que GaAs.

Toutefois, les couches de Ge obtenues peuvent présenter une légère contrainte (paramètre de maille légèrement inférieur à celui de Ge massif) nuisible pour une reprise ultérieure d'une hétéroépitaxie, par exemple de GaAs sur Ge. La couche de Ge pourrait relâcher cette contrainte lors d'une montée en température ultérieure, ce qui aura pour effet regrettable de rendre à nouveau rugueuse la surface et donc de gêner la reprise d'hétéroépitaxie III-V, par exemple en créant des défauts.

Afin d'éviter ce dernier effet, les procédés particulièrement préférés selon l'invention comprennent une étape de stabilisation de la couche de germanium. Cette étape de stabilisation, introduite en fin de croissance de la couche de germanium (avant le polissage mécano-chimique) aura pour effet (1) de relâcher les contraintes et de retrouver le paramètre de maille théorique du germanium, et (2) de stabiliser par conséquent la structure lors de recuits ultérieurs.

Plus précisément, cette étape de stabilisation consiste en un recuit sous atmosphère d'hydrogène à une température allant de 650°C à moins de 900°C pendant une durée suffisante, généralement d'environ 10 minutes ou plus, pour éliminer la contrainte résiduelle. La durée du recuit dépend bien évidemment de la température de recuit et de l'épaisseur de la couche de germanium.

Il est préférable que la température de recuit soit inférieure à 900°C car, au-delà de 900°C, le germanium qui font à 937°C, devient très instable.

Cette étape de stabilisation peut être effectuée dans un four multiplaques classique, cependant elle sera de préférence effectuée in situ (après la croissance de la couche de germanium) afin d'éviter toutes contaminations en espèces carbonées et oxygénées dans un réacteur monoplaque.

Après recuit, la couche de germanium peut subir un polissage mécano-chimique comme décrit précédemment.

Après nettoyage des plaques, par exemple à l'aide d'un bain d'eau ozonée, d'un bain de HF dilué et séchage sous IPA, on peut reprendre une hétéro-épitaxie, par exemple de Ge ou de GaAs.

La suite de la description se réfère aux figures annexées qui représentent, respectivement :

Figure 1 - un graphe des températures de dépôt en fonction du temps (courbe A), ainsi que des graphes des débits des gaz précurseurs $SiH_4$ et $GeH_4$ en fonction du temps (courbes B et C) pour le premier mode de réalisation du procédé selon l'invention ;

Figure 2 - des graphes des débits des gaz précurseurs $SiH_4$ (courbes B et D) et $GeH_4$ (courbes C et E) en fonction du temps, ainsi qu'un graphe des températures de dépôt en fonction du temps (courbe A) ; et

Figure 3 - une microphotographie d'une coupe d'un substrat de silicium monocristallin revêtu, selon le premier mode de réalisation du procédé de l'invention, d'un dépôt de germanium pur monocristallin (zone observée en microscopie électronique sur la tranche)y;

Figure 4 - une microphotographie d'une surface d'un substrat de silicium monocristallin revêtu, selon le premier mode de réalisation du procédé de l'invention, d'un dépôt de germanium pur monocristallin (zone observée en microscopie électronique en vue plan);

Figure 5 - un profil par microscopie à force atomique (AFM) d'une couche de Ge ré-épitaxiée sur une couche de germanium obtenue selon le procédé de l'invention, mais non stabilisée; et

Figure 6 - un profil AFM d'une couche de Ge, ré-épitaxiée sur une couche de germanium obtenue selon le procédé de l'invention, mais stabilisée.

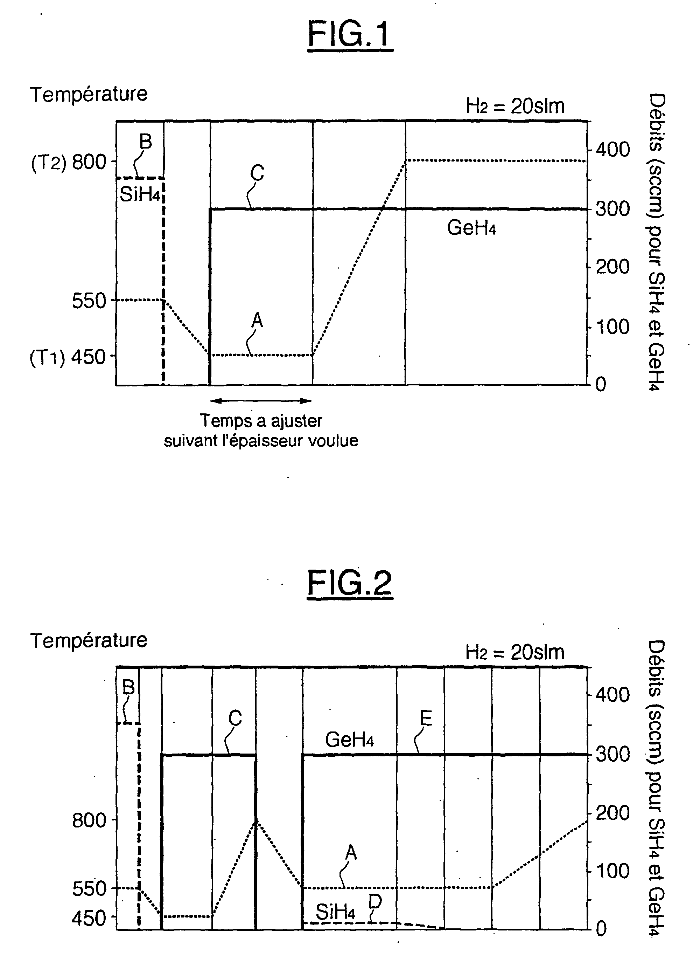

En se référant à la figure 1, on va maintenant décrire une mise en oeuvre préférée du premier mode de réalisation du procédé de l'invention.

Dans un réacteur industriel monoplaque, on place une plaquette de silicium monocristalline (200 mm).

On imprègne la surface de la plaquette par dépôt chimique en phase vapeur de silicium dans les conditions suivantes schématisées à la figure 1 par la courbe B et la partie correspondante de la courbe A.

Pression totale : pression atmosphérique
Température de dépôt : 550°C
Gaz précurseur $SiH_4$ : 350 $cm^3$/minute
Gaz porteur $H_2$ : 20 l/minute
Durée du dépôt : 30 secondes.

On obtient un dépôt d'une couche de silicium de 3 nm environ.

(a) On arrête l'arrivée de $SiH_4$ et on abaisse la température jusqu'à stabilisation à 450°C.
(b) On effectue alors le dépôt CVD d'une couche de germanium monocristallin dans les conditions suivantes :

Pression totale : pression atmosphérique
Température de dépôt ($T_1$) : 450°C
Gaz précurseur $GeH_4$ : 300 $cm^3$/minute
Gaz porteur : $H_2$ : 20 l/minute
Durée de dépôt : 10 minutes.

On obtient une couche de Ge d'épaisseur légèrement inférieure à 1 µm.
(c) On poursuit le dépôt de germanium pendant 60 secondes en accroissant la température de 450 à 850°C et en maintenant toutes les autres conditions de dépôt.
(d) Enfin, on maintient le dépôt de germanium à 850°C ($T_2$) pendant 120 secondes pour obtenir une couche de germanium pur monocristallin ayant une épaisseur de 1 µm.

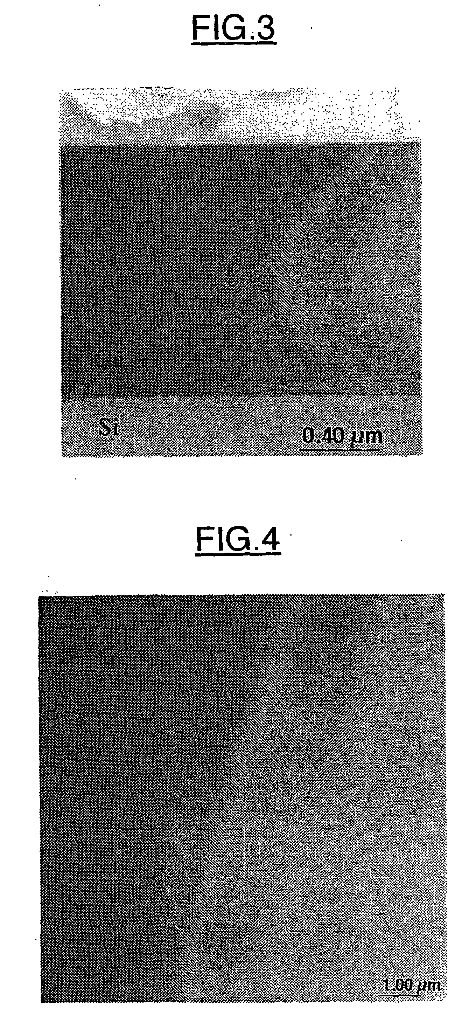

La figure 3 est une microphotographie au microscope électronique à balayage d'une coupe du dépôt obtenu et la figure 4 une vue en plan du dépôt. Ces vues montrent l'absence de dislocations émergentes dans le dépôt de germanium.

On a répété le même procédé de dépôt mais en faisant varier la température finale de dépôt ($T_2$) et on a déterminé la densité de dislocations émergentes.

Les résultats sont donnés dans le tableau I ci-dessous.

TABLEAU I

| $T_2$ . (température finale de dépôt) | Densité de dislocations émergentes défauts/$cm^2$ |
|---|---|
| 700°C | $5.10^5$ |
| 750°C | $5.10^4$ |
| 800°C | $5.10^3$ |
| 830°C | < 10 |
| 850°C | < 10 |

En se référant à la figure 2, on va maitenant décrire une mise en oeuvre préférée du second mode de réalisation du procédé selon l'invention.

La mise en oeuvre du procédé débute comme précédemment par imprégnation de la surface de la plaquette et mise en oeuvre des étapes (a), (b) et (c).

($c_1$) A la fin de l'étape (c), on supprime l'arrivée de $GeH_4$ tout en maintenant le flux de $H_2$ et on abaisse la température de 850°C à 550°C en une minute environ.

($c_2$) On procède alors au dépôt CVD d'une couche d'alliage $Si_{0,1} Ge_{0,9}$ dans les conditions suivantes :

Pression totale : pression atmosphérique
Température de dépôt : 550°C
Flux $GeH_4$ : 300 $cm^3$/minute
Flux $SiH_4$ : 10 $cm^3$/minute

Flux $H_2$ : 20 l/minute
Durée du dépôt : 120 secondes.

On obtient une couche de $Si_{0,1} Ge_{0,9}$ d'environ 15 nm.

($c_3$) Après 120 secondes de dépôt, on supprime progressivement l'arrivée de $SiH_4$ en 60 secondes.

($c_4$) On poursuit alors le dépôt de germanium à 550°C (flux $GeH_4$: 300 cm$^3$) pendant 60 secondes, puis ($c_5$) tout en poursuivant le dépôt de germanium, on accroît en 120 secondes la température de 550°C à 850°C ($T_4$) et (d) on poursuit le dépôt du germanium à cette dernière température pour obtenir la couche de germanium monocristallin d'épaisseur voulue d'environ 1 μm, y compris la couche intermédiaire d'alliage SiGe.

On répète ce procédé en faisant varier la température ($T_2$) de l'étape (b) et la température finale ($T_4$) de l'étape (d).

On a mesuré les densités de dislocations pour chaque couple de températures. Les résultats sont donnés dans le tableau II.

TABLEAU II

| $T_2$ | $T_4$ | Densité de dislocations émergentes défauts/cm$^2$ |
|---|---|---|
| 750°C | 700°C | $1,6 . 10^3$ |
| 750°C | 850°C | $2,5 . 10^2$ |
| 850°C | 850°C | $1,6 . 10^3$ |
| 800°C | 700°C | $2.10^4$ |

On a soumis la plaquette revêtue de la couche (I) de germanium polycristallin obtenue par la mise en oeuvre préférée du premier mode de réalisation du procédé de l'invention décrit ci-dessus, en enchaînant les étapes suivantes :

- nettoyage de la plaquette à l'aide d'un bain d'eau ozonée, d'un bain de HF dilué et séchage sous IPA;
- recuit de la plaquette dans un bâti monoplaque à une température de 650°C environ pendant 30 minutes (la montée en température dure environ 1 minute); et
- épitaxie d'une nouvelle couche (II) de germanium sur la couche de germanium (I) recuite par dépôt chimique en phase vapeur (CVD) dans les conditions ci-dessous :

  - gaz précurseur $GeH_4$
  - gaz porteur $H_2$
  - pression : 2666 Pa (20 Torr)
  - température : environ 670°C

La couche de germanium (II) ré-épitaxie a une épaisseur de 500 nm.

La ré-épitaxie de la couche de germanium (II) peut également se faire à la pression atmosphérique et à une température supérieure à 670°C.

A titre de comparaison, on a ré-épitaxié une couche de germanium (II) dans les mêmes conditions sur une plaquette obtenue de manière identique mais sans l'étape de recuit.

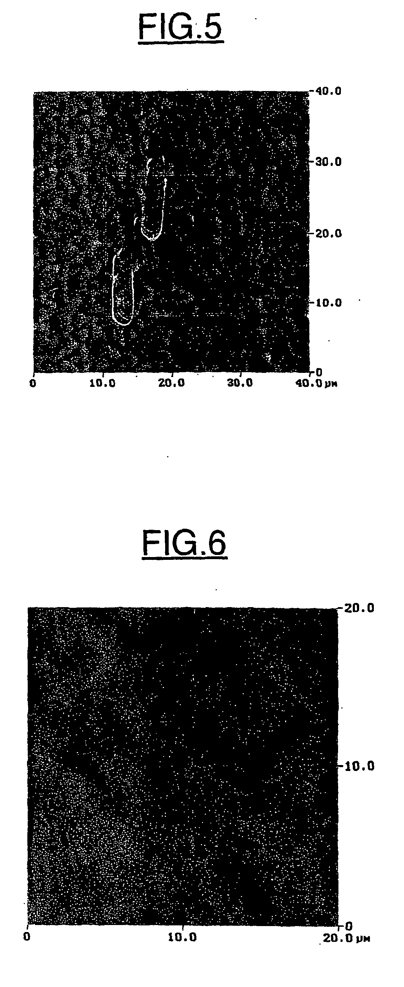

Comme le montrent les figures 5 et 6, la couche de germanium (II) ré-épitaxiée sur une couche de germanium (I) ayant subi un recuit de stabilisation (figure 6) a une rugosité nettement inférieure (rugosité moyenne Ra = 0,311 nm) comparée à la couche de germanium (II) ré-épitaxiée sur une couche de germanium (I) non stabilisée (figure 5) (rugosité moyenne Ra = 1,412 nm).

**Revendications**

**1.** Procédé de formation sur un substrat de silicium monocristallin d'une couche de germanium monocristallin, **caractérisé en ce qu'**il comprend :

(a) la stabilisation en température du substrat de silicium monocristallin à une première température prédéterminée ($T_1$) de 400 à 500°C;
(b) le dépôt chimique en phase vapeur (CVD) de germanium à ladite première température prédéterminée ($T_1$) jusqu'à obtention d'une couche de base de germanium sur le substrat, d'une épaisseur prédéterminée inférieure à une épaisseur finale voulue;

(c) l'accroissement de la température de dépôt CVD du germanium depuis ladite première température prédéterminée ($T_1$) jusqu'à une seconde température prédéterminée ($T_2$) de 750°C à 850°C; et
(d) la poursuite du dépôt CVD du germanium à ladite seconde température prédéterminée ($T_2$) jusqu'à obtention de l'épaisseur finale voulue pour la couche de germanium monocristallin.

2. Procédé de formation sur un substrat de silicium monocristallin d'une couche de germanium monocristallin, **caractérisé en ce qu'**il comprend :

(a) la stabilisation en température du substrat de silicium monocristallin à une première température prédéterminée ($T_1$) de 400 à 500°C;
(b) le dépôt chimique en phase vapeur (CVD) de germanium à ladite première température prédéterminée ($T_1$) jusqu'à obtention d'une couche de base de germanium sur le substrat, d'une épaisseur prédéterminée inférieure à une épaisseur finale voulue;
(c) l'accroissement de la température de dépôt CVD du germanium depuis ladite première température prédéterminée ($T_1$) jusqu'à une seconde température prédéterminée ($T_2$) de 750°C à 850°C;
($c_1$) l'arrêt du dépôt CVD de germanium et l'abaissement de la température depuis ladite seconde température prédéterminée ($T_2$) jusqu'à une troisième température prédéterminée ($T_3$) de 500 à 600°C;
($c_2$) le dépôt CVD, à ladite troisième température prédéterminée ($T_3$) d'un alliage $Si_{1-x}Ge_x$ où $x \geq 0,9$ jusqu'à l'obtention d'une couche intermédiaire d'alliage $Si_{1-x}Ge_x$ ayant une épaisseur prédéterminée;
($c_3$) le passage à ladite troisième température prédéterminée ($T_3$) du dépôt CVD de l'alliage $Si_{1-x}Ge_x$ au dépôt CVD de germanium pur;
($c_4$) la poursuite du dépôt CVD du germanium pur à ladite température prédéterminée ($T_3$) de manière à obtenir un empilement de couches comprenant la couche de base de germanium, la couche intermédiaire d'alliage $Si_{1-x}Ge_x$ et une couche supérieure de germanium, l'épaisseur de l'empilement étant inférieure à ladite épaisseur finale voulue;
($c_5$) l'augmentation de la température de dépôt CVD du germanium depuis ladite troisième température prédéterminée ($T_3$) jusqu'à une quatrième température prédéterminée ($T_4$) de 750°C à 850°C; et
(d) la poursuite du dépôt CVD du germanium à ladite quatrième température prédéterminée ($T_4$) jusqu'à obtention de l'épaisseur finale voulue pour la couche de germanium monocristallin.

3. Procédé selon la revendication 2, **caractérisé en ce que** la troisième tempérture prédéterminée ($T_3$) est choisie dans la gamme de températures de 540 à 560°C.

4. Procédé selon la revendication 2 ou 3, **caractérisé en ce que** la quatrième température prédéterminée ($T_4$) est choisie dans la gamme de températures de 800 à 850°C.

5. Procédé selon l'une quelconque des revendications 2 à 4, **caractérisé en ce que** la couche intermédiaire d'alliage $Si_{1-x}Ge_x$ ($x \geq 0,9$) a une épaisseur comprise entre 5 et 10 nm.

6. Procédé selon l'une quelconque des revendications 2 à 5, **caractérisé en ce que** le dépôt CVD de l'alliage $Si_{1-x}Ge_x$ s'effectue à partir d'un mélange de gaz précurseurs comprenant $GeH_4$ et $SiH_4$.

7. Procédé selon l'une quelconque des revendications 1 à 6, **caractérisé en ce que** la seconde température prédéterminée ($T_2$) est choisie dans la gamme de températures de 800 à 850°C.

8. Procédé selon l'une quelconque des revendications 1 à 7, **caractérisé en ce que** la première température prédéterminée ($T_1$) est choisie dans la gamme de températures de 430 à 460°C.

9. Procédé selon l'une quelconque des revendications précédentes, **caractérisé en ce que** les dépôts CVD de germanium comprennent l'utilisation de $GeH_4$ comme gaz précurseur.

10. Procédé selon l'une quelconque des revendications précédentes, **caractérisé en ce que** toutes les étapes (a) à (d) s'effectuent en présence d'hydrogène.

11. Procédé selon l'une quelconque des revendications précédentes, **caractérisé en ce que** toutes les étapes s'effectuent à la pression atmosphérique.

12. Procédé selon l'une quelconque des revendications précédentes, **caractérisé en ce qu'**il comprend, préalablement à l'étape (a), une étape de dépôt CVD d'une couche de silicium d'imprégnation, à une température de 500 à 600°C.

13. Procédé selon la revendication 12, **caractérisé en ce que** la couche de silicium d'imprégnation a une épaisseur de 1 à 5 nm.

14. Procédé selon la revendication 12 ou 13, **caractérisé en ce que** le dépôt CVD de la couche de silicium d'imprégnation s'effectue à la pression atmosphérique.

15. Procédé selon l'une quelconque des revendications 1 à 14, **caractérisé en ce qu'**il comprend une étape de polissage mécano-chimique de la couche de germanium pur monocristallin.

16. Procédé selon l'une quelconque des revendications précédentes, **caractérisé en ce qu'**il est mis en oeuvre dans un réacteur mono-plaque.

17. Procédé selon l'une quelconque des revendications précédentes, **caractérisé en ce qu'**il comprend (e) une étape de recuit de stabilisation de la couche de germanium obtenue à l'étape (d).

18. Procédé selon la revendication 17, **caractérisé en ce que** l'étape de recuit s'effectue à une température de 650°C à moins de 900°C.

19. Procédé selon la revendication 17 ou 18, **caractérisé en ce que** l'étape de recuit a une durée d'au moins 10 minutes.

20. Procédé selon l'une quelconque des revendications 17 à 19, **caractérisé en ce qu'**il comprend en outre une étape de ré-épitaxie d'un élément des groupes III à V de la classification périodique ou d'un composé de ceux-ci.

21. Procédé selon la revendication 20, **caractérisé en ce que** l'élément ou le composé ré-épitaxié est Ge ou GaAs.

22. Procédé selon l'une quelconque des revendications 20 ou 21, **caractérisé en ce qu'**il comprend une étape de polissage mécano-chimique de la couche ré-épitaxiée.


**Patentansprüche**

1. Verfahren zur Herstellung einer einkristallinen Schicht von Germanium auf einem Substrat von einkristallinem Silizium, **dadurch gekennzeichnet, daß** es umfaßt:

   (a) Stabilisierung der Temperatur des Substrates von einkristallinem Silizium auf einer vorbestimmten ersten Temperatur ($T_1$) von 400 bis 500°C;
   (b) chemische Dampfphasenabscheidung (CVD) von Germanium bei dieser vorbestimmten ersten Temperatur ($T_1$) bis zum Erhalt einer Basisschicht von Germanium auf dem Substrat von einer vorbestimmten Dicke unterhalb einer gewünschten Enddicke;
   (c) Erhöhung der CVD-Abscheidungstemperatur des Germaniums von dieser vorbestimmten ersten Temperatur ($T_1$) bis auf eine vorbestimmte zweite Temperatur ($T_2$) von 750°C bis 850°C; und
   (d) Fortsetzen der CVD-Abscheidung von Germanium bei dieser vorbestimmten zweiten Temperatur ($T_2$) bis zum Erhalt der gewünschten Enddicke für die einkristalline Germaniumschicht.

2. Verfahren zur Herstellung einer einkristallinen Schicht von Germanium auf einem Substrat von einkristallinem Silizium, **dadurch gekennzeichnet, daß** es umfaßt:

   (a) Stabilisierung der Temperatur des Substrates von einkristallinem Silizium auf einer vorbestimmten ersten Temperatur ($T_1$) von 400 bis 500°C;
   (b) chemische Dampfphasenabscheidung (CVD) von Germanium bei dieser vorbestimmten ersten Temperatur ($T_1$) bis zum Erhalt einer Basisschicht von Germanium auf dem Substrat von einer vorbestimmten Dicke unterhalb einer gewünschten Enddicke;
   (c) Erhöhung der CVD-Absscheidungstemperatur des Germaniums von dieser vorbestimmten ersten Temperatur ($T_1$) bis auf eine vprbestimmte zweite Temperatur ($T_2$) von 750°C bis 850°C;

($c_1$) Anhalten der CVD-Abscheidung des Germaniums und Absenken der Temperatur von dieser vorbestimmten zweiten Temperatur ($T_2$) bis auf eine vorbestimmte dritte Temperatur ($T_3$) von 500 bis 600°C;

($c_2$) CVD-Abscheidung bei dieser vorbestimmten dritten Temperatur ($T_3$) einer Legierung $Si_{1-x}Ge_x$, worin $x \geq 0{,}9$, bis zum Erhalt einer Legierungszwischenschicht $Si_{1-x}Ge_x$, die eine vorbestimmte Dicke hat;

($c_3$) Übergang auf diese vorbestimmte dritte Temperatur ($T_3$) der CVD-Abscheidung der Legierung $Si_{1-x}Ge_x$ zur CVD-Abscheidung von reinem Germanium;

($c_4$) Fortsetzen der CVD-Abscheidung von reinem Germanium bei dieser vorbestimmten dritten Temperatur ($T_3$) derart, um eine Aufeinanderstapelung von Schichten zu erhalten, welche die Basisschicht von Germanium, die Zwischenschicht der Legierung $Si_{1-x}Ge_x$ und eine obere Schicht von Germanium umfaßt, wobei die Dicke der Aufeinanderstapelung unterhalb dieser gewünschten Enddicke liegt;

($c_5$) Erhöhung der CVD-Abscheidungstemperatur des Germaniums von dieser vorbestimmten dritten Temperatur ($T_3$) bis auf eine vorbestimmte vierte Temperatur ($T_4$) von 750°C bis 850°C; und

(d) Fortsetzen der CVD-Abscheidung von Germanium bei dieser vorbestimmten vierten Temperatur ($T_4$) bis zum Erhalt der gewünschten Enddicke für die einkristalline Germaniumschicht.

3. Verfahren nach Anspruch 2, **dadurch gekennzeichnet, daß** die vorbestimmte dritte Temperatur ($T_3$) in dem Temperaturbereich von 540 bis 560°C ausgewählt wird.

4. Verfahren nach Anspruch 2 oder 3, **dadurch gekennzeichnet, daß** die vorbestimmte vierte Temperatur ($T_4$) in dem Temperaturbereich von 800 bis 850°C ausgewählt wird.

5. Verfahren nach einem der Ansprüche 2 bis 4, **dadurch gekennzeichnet, daß** die Zwischenschicht der Legierung $Si_{1-x}Ge_x$ ($x \geq 0{,}9$) eine Dicke zwischen 5 und 10 nm hat.

6. Verfahren nach einem der Ansprüche 2 bis 5, **dadurch gekennzeichnet, daß** die CVD-Abscheidung der Legierung $Si_{1-x}Ge_x$ aus einer Mischung von Gasvorläufern, die $GeH_4$ und $SiH_4$ umfaßt, erfolgt.

7. Verfahren nach einem der Ansprüche 1 bis 6, **dadurch gekennzeichnet, daß** die vorbestimmte zweite Temperatur ($T_2$) in dem Temperaturbereich von 800 bis 850°C ausgewählt wird.

8. Verfahren nach einem der Ansprüche 1 bis 7, **dadurch gekennzeichnet, daß** die vorbestimmte erste Temperatur ($T_1$) in dem Temperaturbereich von 430 bis 460°C ausgewählt wird.

9. Verfahren nach einem der vorhergehenden Ansprüche, **dadurch gekennzeichnet, daß** die CVD-Abscheidungen von Germanium die Verwendung von $GeH_4$ als Vorläufergas umfassen.

10. Verfahren nach einem der vorhergehenden Ansprüche, **dadurch gekennzeichnet, daß** alle Stufen (a) bis (d) in Anwesenheit von Wasserstoff durchgeführt werden.

11. Verfahren nach einem der vorhergehenden Ansprüche, **dadurch gekennzeichnet, daß** alle Stufen bei atmosphärischem Druck durchgeführt werden.

12. Verfahren nach einem der vorhergehenden Ansprüche, **dadurch gekennzeichnet, daß** es vor der Stufe (a) eine Stufe der CVD-Abscheidung einer Imprägnierschicht von Silizium bei einer Temperatur von 500 bis 600°C umfaßt.

13. Verfahren nach Anspruch 12, **dadurch gekennzeichnet, daß** die Imprägnierschicht von Silizium eine Dicke von 1 bis 5 nm hat.

14. Verfahren nach Anspruch 12 oder 13, **dadurch gekennzeichnet, daß** die CVD-Abscheidung der Imprägnierschicht von Silizium bei atmosphärischem Druck durchgeführt wird.

15. Verfahren nach einem der Ansprüche 1 bis 14, **dadurch gekennzeichnet, daß** es eine Stufe des mechanisch-chemischen Polierens der Schicht von einkristallinem reinem Germanium umfaßt.

16. Verfahren nach einem der vorhergehenden Ansprüche, **dadurch gekennzeichnet, daß** es in einem Einzelscheiben-Reaktor durchgeführt wird.

17. Verfahren nach einem der vorhergehenden Ansprüche, **dadurch gekennzeichnet, daß** es eine Stufe (e) des Anlassens zur Stabilisierung der in Stufe (d) erhaltenen Germaniumschicht umfaßt.

18. Verfahren nach Anspruch 17, **dadurch gekennzeichnet, daß** die Stufe des Anlassens bei einer Temperatur von 650°C bis weniger als 900°C erfolgt.

19. Verfahren nach Anspruch 17 oder 18, **dadurch gekennzeichnet, daß** die Stufe des Anlassens eine Dauer von wenigstens 10 Minuten hat.

20. Verfahren nach einem der Ansprüche 17 bis 19, **dadurch gekennzeichnet, daß** sie außerdem eine Stufe der Re-Epitaxie eines Elementes der Gruppen III bis V des Periodensystems oder einer Verbindung von diesen umfaßt.

21. Verfahren nach Anspruch 20, **dadurch gekennzeichnet, daß** das re-epitaxierte Element oder die re-epitaxierte Verbindung Ge oder GaAs ist.

22. Verfahren nach einem der Ansprüche 20 oder 21, **dadurch gekennzeichnet, daß** es eine Stufe des mechanisch-chemischen Polierens der re-epitaxierten Schicht umfaßt.

## Claims

1. Process for forming a layer of single-crystal germanium on a substrate of single-crystal silicon, **characterized in that** it comprises:

   (a) temperature stabilization of the single-crystal silicon substrate at a first predetermined temperature ($T_1$) of 400 to 500°C;
   (b) chemical vapor deposition (CVD) of germanium at said first predetermined temperature ($T_1$) until a germanium base layer with a predetermined thickness of less than a desired final thickness is obtained on the substrate;
   (c) increase in the germanium CVD deposition temperature from the first predetermined temperature ($T_1$) to a second predetermined temperature ($T_2$) ranging from 750°C to 850°C; and
   (d) continuation of the germanium CVD deposition at said second predetermined temperature ($T_2$) until the desired final thickness of the single-crystal germanium layer is obtained.

2. Process for forming a layer of single-crystal germanium on a substrate of single-crystal silicon, **characterized in that** it comprises:

   (a) temperature stabilization of the single-crystal silicon substrate at a first predetermined temperature ($T_1$) of 400 to 500°C;
   (b) chemical vapor deposition (CVD) of germanium at said first predetermined temperature ($T_1$) until a germanium base layer with a predetermined thickness of less than a desired final thickness is obtained on the substrate;
   (c) increase in the germanium CVD deposition temperature from said first predetermined temperature ($T_1$) up to a second predetermined temperature ($T_2$) of 750°C to 850°C;
   ($c_1$) stopping of the germanium CVD deposition and lowering of the temperature from said second predetermined temperature ($T_2$) down to a third predetermined temperature ($T_3$) of 500 to 600°C;
   ($c_2$) CVD deposition, at said third predetermined temperature ($T_3$), of an $Si_{1-x}Ge_x$ alloy where $x \geq 0.9$ until an $Si_{1-x}Ge_x$ alloy interlayer having a predetermined thickness is obtained;
   ($c_3$) transition, at said third predetermined temperature ($T_3$), from CVD deposition of the $Si_{1-x}Ge_x$ alloy to CVD deposition of pure germanium;
   ($c_4$) continuation of the CVD deposition of pure germanium at said predetermined temperature ($T_3$) so as to obtain a multilayer stack comprising the germanium base layer, the $Si_{1-x}Ge_x$ alloy interlayer and a germanium top layer, the thickness of the stack being less than said desired final thickness;
   ($c_5$) increase in the germanium CVD deposition temperature from said third predetermined temperature ($T_3$) up to a fourth predetermined temperature ($T_4$) of 750°C to 850°C; and
   (d) continuation of the germanium CVD deposition at said fourth predetermined temperature ($T_4$) until the desired final thickness of the single-crystal germanium layer is obtained.

3. Process according to claim 2, **characterized in that** the third predetermined temperature ($T_3$) is chosen within the 540 to 560°C temperature range.

4. Process according to claim 2 or 3, **characterized in that** the fourth predetermined temperature ($T_4$) is chosen within the 800 to 850°C temperature range.

5. Process according to any one of claims 2 to 4, **characterized in that** the $Si_{1-x}Ge_x$ alloy interlayer ($x \geq 0.9$) has a thickness of between 5 and 10 nm.

6. Process according to any one of claims 2 to 5, **characterized in that** the CVD deposition of the $Si_{1-x}Ge_x$ alloy is carried out using a mixture of precursor gases comprising $GeH_4$ and $SiH_4$.

7. Process according to any one of claims 1 to 6, **characterized in that** the second predetermined temperature ($T_2$) is chosen within the 800 to 850°C temperature range.

8. Process according to any one of claims 1 to 7, **characterized in that** the first predetermined temperature ($T_1$) is chosen within the 430 to 460°C temperature range.

9. Process according to any one of the preceding claims, **characterized in that** the germanium CVD deposition uses $GeH_4$ as precursor gas.

10. Process according to any one of the preceding claims, **characterized in that** all steps (a) to (d) are carried-out in the presence of hydrogen.

11. Process according to any one of the preceding claims, **characterized in that** all the steps are carried out at atmospheric pressure.

12. Process according to any one of the preceding claims, **characterized in that** it includes, prior to step (a), a step of CVD deposition of a silicon impregnation layer at a temperature of 500 to 600°C.

13. Process according to claim 12, **characterized in that** the silicon impregnation layer has a thickness of 1 to 5 nm.

14. Process according to claim 12 or 13, **characterized in that** the CVD deposition of the silicon impregnation layer is carried out at atmospheric pressure.

15. Process according to any one of claims 1 to 14, **characterized in that** it includes a step of chemical-mechanical polishing of the pure single-crystal germanium layer.

16. Process according to any one of the preceding claims, **characterized in that** it is carried in a single-wafer reactor.

17. Process according to any one of the preceding claims, **characterized in that** it includes a step (e) of stabilization annealing of the germanium layer obtained in step (d).

18. Process according to claim 17, **characterized in that** the annealing step is carried out at a temperature of between 650°C and less than 900°C.

19. Process according to claim 17 or 18, **characterized in that** the annealing step has a duration of at least 10 minutes.

20. Process according to any one of claims 17 to 19, **characterized in that** it furthermore includes a step of epitaxially regrowing an element from Groups III to V of the Periodic Table or of a compound of them.

21. Process according to claim 20, **characterized in that** the epitaxially regrown element or compound is Ge or GaAs.

22. Process according to either of claims 20 and 21, **characterized in that** it includes a step of chemical-mechanical polishing of the epitaxially regrown layer.

# FIG.1

# FIG.2

# FIG.3

# FIG.4

## FIG.5

## FIG.6